(19) Europäisches Patentamt
European Patent Office
Office européen des brevets

(11) EP 2 195 675 B1

# (12) EUROPEAN PATENT SPECIFICATION

(45) Date of publication and mention of the grant of the patent:
**05.12.2012 Bulletin 2012/49**

(21) Application number: **08807455.4**

(22) Date of filing: **27.08.2008**

(51) Int Cl.:
***G01R 33/09*** *(2006.01)*

(86) International application number:
**PCT/IB2008/053449**

(87) International publication number:
**WO 2009/040692 (02.04.2009 Gazette 2009/14)**

## (54) MAGNETORESISTANCE SENSOR AND METHOD OF OPERATING A MAGNETORESISTANCE SENSOR

MAGNETWIDERSTANDSSENSOR UND VERFAHREN ZUM BETREIBEN EINES MAGNETWIDERSTANDSSENSORS

CAPTEUR DE RÉSISTANCE MAGNÉTIQUE ET SON PROCÉDÉ D'EXPLOITATION

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **25.09.2007 EP 07117124**

(43) Date of publication of application:
**16.06.2010 Bulletin 2010/24**

(73) Proprietor: **NXP B.V.**
**5656 AG Eindhoven (NL)**

(72) Inventors:
- **BUTZMANN, Stefan**
  **5656 AE Eindhoven (DE)**
- **PROCHASKA, Marcus**
  **5656 AE Eindhoven (DE)**

(74) Representative: **Schwarzweller, Thomas et al**
**NXP Semiconductors Germany GmbH**
**Intellectual Property & Licensing Department**
**Stresemannallee 101**
**22529 Hamburg (DE)**

(56) References cited:
**WO-A-2005/010543**
**WO-A-2007/042959**
**US-A- 4 703 378**
**US-A1- 2006 132 125**

- **FLYNN D: "Demodulation of a magnetoresistive sensor signal to achieve a low-cost, stable and high-resolution vector magnetometer" SENSORS AND ACTUATORS A, ELSEVIER SEQUOIA S.A., LAUSANNE, CH, vol. 50, no. 3, 1 September 1995 (1995-09-01), pages 187-190, XP004303535 ISSN: 0924-4247**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 195 675 B1

## Description

FIELD OF THE INVENTION

The invention relates to a magnetoresistance sensor.

The invention further relates to a method of operating a magnetoresistance sensor.

Moreover, the invention relates to a program element.

Further, the invention relates to a computer-readable medium.

BACKGROUND OF THE INVENTION

Magnetoresistance or magnetoresistive sensors like anisotropic magnetoresistance sensors (AMR) or giant magnetoresistance sensors (GMR) are widely used nowadays. For example, AMR sensors are key-building blocks in many automotive applications, e.g. for antilock braking systems (ABS), engine management, transmission or security systems. Especially in the field of automotive transmission a large air gap capability is required.

Typically, magnetoresistive sensors for rotational speed measurements are linearized by a Barber pole construction. Since Barber pole sensors possess two stable output characteristics a bias magnet is necessary to prevent flipping between positive and negative magnetization directions. However, the auxiliary field $H_x$ in x-direction, i.e. parallel to the easy axis of the magnetoresistive sensor, provided by the bias magnet reduces the sensitivity as shown in the following equation:

$$\frac{dR_{sensor}}{dH} \sim \frac{1}{H_0 + H_x} \qquad (1)$$

A main disadvantage of Barber pole sensors is reduced sensitivity caused by this auxiliary field. Furthermore, for increasing air gaps the output signal of the sensor head decreases which leads to heavy requirements for the signal processing and conditioning units of smart sensor systems. Thus, state of the art AMR speed sensors equipped with standard magnets consisting of iron, ferrite, or AlNiCo-alloy are not able to provide air cap capabilities which are required in many fields of applications such as automotive transmission systems.

Prior art magnetoresistive sensor systems using oscillating excitational fields are disclosed in US 4 703 378 A, US 2006/132125 A1 and Flynn D.: "Demodulation of a magnetoresistive sensor signal to achieve a low-cost stable and high-resolution vector magnetometer", Sensors and Actuators A 50 (1995) 187-190.

Thus, there may be a need to provide a magnetoresistive sensor having an improved sensitivity.

SUMMARY OF THE INVENTION

It is an object of the invention to provide a magnetoresistive sensor system having an improved sensitivity and a method of operating the same.

In order to achieve the object defined above, a magnetoresistive sensor system, a method of operating a magnetoresistive sensor system, a program element, and a computer-readable medium according to the independent claims are provided.

According to an exemplary embodiment a device a magnetoresistive sensor system is provided, wherein the system comprises a magnetic field source, a magnetoresistive sensor having an easy axis, and a differentiation element, wherein the magnetic field source is adapted to emit an auxiliary magnetic field from an oscillating input signal, wherein the auxiliary magnetic field is orthogonal to the easy axis of the magnetoresistive sensor, wherein the magnetoresistive sensor is adapted to sense a signal associated to a superposition of an external magnetic field and the auxiliary alternating magnetic field, and wherein the differentiation element is adapted to differentiate the sensed signal. In particular, the magnetoresistive sensor may be a non-linearized magnetoresistive sensor, e.g. may not have linearized characteristics like a Barber pole sensor as known in the prior art. In particular, the differentiation element may be adapted to perform a differentiation in time of the sensed signal. The auxiliary field may also be called exciting field.

According to an exemplary embodiment a method of linearizing a sensor transfer function of a magnetoresistive sensor is provided, the method comprises generating an auxiliary magnetic field orthogonal to an easy axis of the magnetoresistive sensor, sensing a signal associated to a superposition of an external magnetic field and the auxiliary alternating magnetic field, and differentiating the sensed signal. In particular, the differentiation may be performed by using a differentiation element.

According to an exemplary embodiment a program element is provided, which, when being executed by a processor, is adapted to control or carry out a method according to an exemplary embodiment.

According to an exemplary embodiment a computer-readable medium is provided, in which a computer program is stored which, when being executed by a processor, is adapted to control or carry out a method according to an exemplary embodiment.

Such a provision of a differentiation of the sensed signal of a magnetoresistive sensor by an additional alternating field perpendicular to the easy axis of the magnetoresistive sensor may improve the sensitivity of the magnetoresistive sensor system. In this case the sensitivity of the magnetoresistive sensor system may only be limited by the accuracy of time measurement. Therefore, it may be possible to provide a larger sensing distance, i.e. it may be possible to implement a larger air gap which may be a key requirement for automotive transmission applications. Such an improved sensitivity of a magnetoresistive sensor may also open up new fields of application. In particular, compared to the known Barber pole sensor the saving of the additional bias magnet may lead to reduced production costs. In general such a magnetoresistive sensor system may be used in rotational speed sensors in the automotive sector. Due to the increased sensitivity it may be possible to reliable measure weak magnetic fields. In particular, a magnetoresistive sensor system according to an exemplary embodiment may provide a phase modulation of the signal to be sensed.

A gist of an exemplary aspect of the invention may be seen in the fact that the sensed signal is quasi phase modulated by using a differentiation element. Thus, the measurement of weak magnetic fields may be performed by a duty cycle analysis. To provide a signal where the duty cycle corresponds to the magnitude of an external magnetic field to be measured, an alternating excitation of the sensor element as well as an adequate signal pre-processing may be performed. For the excitation an auxiliary or exciting magnetic field is used, which excites the magnetoresistive sensor and is superimposed to the external magnetic field to be measured. Thus, has an orthogonal direction than the known auxiliary magnetic fields used for Barber pole sensors to suppress flipping. The exciting magnetic field has a polarization which is orthogonal to the easy axis of the magnetoresistive sensor. Such an exciting magnetic field may be generated by a coil which is implemented in a chip the magnetoresistive sensor itself is implemented. In particular, the magnetoresistive sensor may be formed by a non-linear element, i.e. a magnetization sensor having a non-linear transfer function, so that the external field may modulate the amplitude of the excitation. Starting from this amplitude modulated excitation signal a new signal may be derived, where the duty cycle represents the magnitude of the external magnetic field. In this case the sensitivity of the magnetoresistive sensor system may only be limited by the accuracy of time measurement.

Summarizing, the basic embodiment of an exemplary magnetoresistive sensor system may be the provision of a magnetic field source which provides or generates an auxiliary magnetic field which is an alternating field and has a direction which is orthogonal to the easy axis of a magnetoresistive sensor of the magnetoresistive sensor system. The modulated signal may then be processed by a differentiation element in order to achieve a phase modulated sensor signal.

Next, further exemplary embodiments of the invention will be described.

In the following, further exemplary embodiments of the magnetoresistive sensor system will be explained. However, these embodiments also apply for the method of linearizing a sensor transfer function of a magnetoresistive sensor, for the program element and for the computer-readable medium.

According to another exemplary embodiment of the magnetoresistive sensor system the magnetoresistive sensor is an anisotropic magnetoresistive sensor and/or and giant magnetoresistive sensor.

According to another exemplary embodiment the magnetoresistive sensor system further comprises a mixer adapted to mix the differentiated signal and the oscillating input signal. In particular, the oscillating input signal may also be differentiated before it is fed to the mixer. For the provision of the differentiated oscillating input signal a further differentiation unit or element may be provided.

According to another exemplary embodiment the magnetoresistive sensor system further comprises a lowpass filter, wherein the lowpass filter is adapted to filter the mixed filtered signal.

The provision of a lowpass filter may be a suitable measure to suppress and/or eliminate distortions in an output signal of the magnetoresistive sensor system.

According to another exemplary embodiment of the magnetoresistive sensor system the magnetic field source is a coil.

In particular, the oscillating signal may be provided by an oscillator providing a driving signal for the coil. Specifically, the oscillating signal may be a sinusoidal signal.

The exemplary embodiments and aspects defined above and further aspects of the invention are apparent from the examples of embodiment to be described hereinafter and are explained with reference to these examples of embodiment. In particular, it should be noted that features which are described in connection with one exemplary embodiment or aspect may be combined with other exemplary embodiments and other exemplary aspects.

## BRIEF DESCRIPTION OF THE DRAWINGS

The invention will be described in more detail hereinafter with reference to examples of embodiment but to which the invention is not limited.

Fig. 1 schematically shows a simplified circuit diagram of a current fed anisotropic magnetoresistive (AMR) sensor.
Fig. 2 schematically shows superposition of a magnetic excitation and an external magnetic field.
Fig. 3 schematically shows phase modulated sensor signals.
Fig. 4 shows a schematically block diagram of elements of an analog processing unit.
Fig. 5 shows a schematically block diagram of a digital signal processing unit.

DESCRIPTION OF EMBODIMENTS

The illustration in the drawing is schematically. In different drawings, similar or identical elements are provided with similar or the same reference signs.

In the following, referring to Figs. 1 to 5 some basic principles of a magnetoresistive sensor system according to an exemplary embodiment will be explained.

**Fig. 1** shows a simplified circuit diagram of a current fed anisotropic magnetoresistive sensor (AMR sensor) 100 with sinusoidal excitation. In detail Fig. 1 shows a magnetic field source 101 comprising a drive coil 102 and a source 103 of an oscillating voltage, e.g. an oscillator. Furthermore, Fig. 1 shows a magnetoresistive sensor 104 comprising an AMR element 105. In particular, it should be noted that the easy axis of the AMR element 105 has a direction which is substantially vertical in Fig. 1, i.e. in the direction of the voltage $U_{sensor}$ indicated in Fig. 1, while the direction of the magnetic field induced by the drive coil 102 is substantially horizontally in Fig. 1, i.e. substantially parallel to the voltage $U_{exc}$ indicated in Fig. 1. In particular, it should be noted that the AMR element 104 is a non-linearized AMR element, i.e. does not provide a linearized output signal as a Barber pole for example. The drive coil 102 generates a sinusoidal magnetic excitation in y-direction, i.e. in a direction orthogonal to the easy axis of the AMR element, commonly referred to as the x-direction.

For small magnetic fields $H_y$ in y-direction or a negligible field in x-direction ($H_x \rightarrow 0$) AMR sensors without Barber poles can be described by

$$R_{sensor} = R_0 + \Delta R \left( 1 - \left( \frac{H_y}{H_0} \right)^2 \right) \qquad (2)$$

wherein $H_0$ represents a constant comprising the so-called demagnetizing and anisotropic field. The excitation created by the drive coil is given by

$$H_{exc}(t) = \hat{H}_{exc} \sin(\omega_{exc} t) \qquad (3)$$

wherein $H_{exc}$ represents the excitation magnetic field induced by the drive coil and $\hat{H}_{exc}$ represents the amplitude of the same. The coil is driven by an oscillation voltage source or oscillatory circuit by a voltage according to the following equation:

$$u_{exc}(t) = \hat{U}_{exc} \sin(\omega_{exc} t). \qquad (4)$$

In the following the magnetic field which has to be measured is called the external field $H_{ext}$, which remains constant for an adequate choice of $\omega_{exc} = 2\pi f_{exc}$. So we find the magnetic input signal of the AMR sensor:

$$H_y(t) = H_{ext} + \hat{H}_{exc} \sin(\omega_{exc} t). \qquad (5)$$

**Fig. 2** schematically shows the superposition of the external magnetic field and the excitation magnetic field. In particular, Fig. 2 shows the resistance R in Ω over the field Hy in A/m as the line 201. Furthermore, the magnetic fields $H_{ext}(t)$ and $H_{exc}(t)$ are schematically shown as lines 202 and 203, respectively. As mentioned above as $H_{exc}(t)$ is used a sinusoidal excitation is used. As can be seen in Fig. 2 the resistance distribution is a symmetric distribution, i.e. the resistance is identical for $-H_y$ and $+H_y$.

Starting from the equations (1) and (4) the resulting $R_{sensor}(t)$ can be calculated and represents an amplitude modulation of $H_{exc}$ by $H_{ext}$. If equation (5) is put into (2) and for $R_0 \gg \Delta R$ the following equation will be achieved:

$$R_{sensor}(t) = R_0 - \Delta R\left(\frac{H_{ext} + \hat{H}_{exc}\sin(\omega_{exc}t)}{H_0}\right)^2. \quad (6)$$

For $I_{sensor}$ = const. the output of the sensor is given by:

$$u_{sensor}(t) = R_0 I_{sensor} - \Delta R I_{sensor}\left(\frac{H_{ext} + \hat{H}_{exc}\sin(\omega_{exc}t)}{H_0}\right)^2. \quad (7)$$

From equation (7) follows:

$$\frac{du_{sensor}}{dt} = -2\omega_{exc}\Delta R I_{sensor}\hat{H}_{exc}\left(\frac{H_{ext} + \hat{H}_{exc}\sin(\omega_{exc}t)}{H_0}\right)\cos(\omega_{exc}t). \quad (8)$$

The product of (8) and

$$\frac{du_{exc}}{dt} = \omega_{exc}\hat{U}_{exc}\cos(\omega_{exc}t) \quad (9)$$

leads to:

$$m(t) = \frac{du_{sensor}}{dt}\frac{du_{exc}}{dt} = -\omega_{exc}^2\Delta R I_{sensor}\hat{U}_{exc}\hat{H}_{exc}\left(\frac{H_{ext} + \hat{H}_{exc}\sin(\omega_{exc}t)}{H_0^2}\right)(1 + \cos(2\omega_{exct})). \quad (10)$$

which corresponds to the signal after mixing of the time differentiated sensed signal and the time differentiated excitation signal.

After lowpass filtering with a cut-off frequency of approximately $f_{exc}$ a signal u(t)

$$u(t) = -\omega_0^2\Delta R I_{sensor}\hat{U}_{exc}\hat{H}_{exc}\left(\frac{H_{ext} + \hat{H}_{exc}\sin(\omega_{exc}t)}{H_0^2}\right), \quad (11)$$

can be derived, which is shown in Fig. 3 and will be described in more detail later on.

The signal u(t), which can be derived by a signal processing unit of a magnetoresistive sensor system shown in Fig. 4 has a zero crossing at

$$t_{root} = \frac{1}{\omega_{exc}}\arcsin\left(-\frac{H_{ext}}{\hat{H}_{exc}}\right), \quad (12)$$

which defines a change in the duty cycle of the corresponding signal

$$u^*(t) = \begin{cases} 1 & for \quad u(t) \geq 1 \\ -1 & \quad\quad u(t) < 1 \end{cases} \quad (13)$$

by

$$\Delta t = | t_{root} | . \quad (14)$$

This means that for a positive external field $H_{ext}$ u(t) is positive for t=[0,T/2+2Δt] and negative for t=[T/2+2Δt,T] as shown in Fig. 3. So it is possible to define two time domains for a positive

$$t_{positive} = \frac{T}{2} \pm 2\Delta t \quad (15)$$

and a negative

$$t_{negative} = \frac{T}{2} \mp 2\Delta t \quad (16)$$

signal u*(t). The difference of (15) and (16) is offset free and corresponds to the magnitude of the external field:

$$t_H = t_{positive} - t_{negative} = 4\Delta t = 4\left|\arcsin\left(-\frac{H_{ext}}{H_{exc}}\right)\right|. \quad (17)$$

In order to get the time interval $t_H$ an analog as well as a digital implementation is possible. Since digital signal processing has the advantage of an implicit analog-to-digital conversion, a digital realization is preferred.

The signals u(t) and u*(t) are depicted in Fig. 3. In detail in the upper part of **Fig. 3** the signal u(t) is shown, i.e. the phase modulated mixed signal, which depends on $H_{exc}$, e.g. is proportional. Beside the sinusoidal signal labelled 301 some intervals are marked in Fig. 3. In detail these intervals are the interval of $\frac{T}{2} + 2\Delta t$ labelled 302 and which lies between the lines 303 and 304, and $\frac{T}{2} - 2\Delta t$ labelled 305 and which lies between the lines 304 and 306. A third interval 307 is depicted as well and corresponds to the period $T=2\pi/\omega_{exc}$ of the signal and which lies between the lines 308 and 309. Furthermore, the external signal $H_{ext}$ and which corresponds to a shift of the signal u(t) is depicted in Fig. 3.

In the lower part of Fig. 3 the corresponding signal u*(t) 310 is depicted, i.e. the signal corresponding to equation (13).

As already mentioned **Fig. 4** schematically shows a block diagram of a signal processing unit which can be used to derive the signal u(t). In detail Fig. 4 shows a schematically block diagram of a portion of a magnetoresistive sensor system 400 according to an exemplary embodiment including a processing unit. The magnetoresistive sensor system comprises an oscillator 401 adapted to generate a driving signal, e.g. a sinusoidal voltage signal, which can be fed into a drive coil 402. The drive coil 402 generates an exciting magnet field $H_{exc}$ which is superimposed to an external magnet field $H_{ext}$ to be measured. Furthermore, the magnetoresistive sensor system comprises a magnetoresistive sensor 403, e.g. an anisotropic magnetoresistive sensor or a giant magnetoresistive sensor, which measures the superimposed magnet field. It should be noted that the magnetoresistive sensor has an easy axis having a direction which is orthogonal to the direction of the exciting magnet field $H_{exc}$. An output signal of the magnetoresistive sensor 403 is a sensor voltage $U_{sensor}$ which is fed into a first differentiation unit 404. The differentiated signal of the magnetoresistive sensor 403 is then fed into a mixer 405 together with the sinusoidal voltage signal of the oscillator 401 which is also differentiated by a second differentiation unit 406. Afterwards, the mixed signal m(t) is fed into a lowpass filter 407 which generates the output voltage u(t).

**Fig. 5** shows a schematically block diagram of a digital signal processing unit 500. The digital signal processing unit 500 comprises a comparator 501 into which the output signal u(t) is fed and compared with ground GND. Furthermore, the digital signal processing unit 500 comprises an up/down counter 502 into which an output signal of the comparator 501 is fed and which counts up for a positive u*(t) and down if u*(t) is negative. For a rising edge of $U / \overline{D}$ the counter output is valid and proportional to $t_H$. After that a reset of the counter is needed in order to prepare the next measurement. In particular, it should be mentioned that the sensitivity of the smart magnetoresistive sensor system only depends on the clock frequency of the digital counter.

Summarizing according to an exemplary aspect of the invention a magnetoresistive sensor system may be provided which is based on a non-linearized magnetoresistive sensor. In order to measure weak magnetic fields an exciting magnet field $H_{exc}$ is used which is generated by using a sinusoidal signal and has a direction which is orthogonal to the easy axis of the magnetoresistive sensor. A differentiation element is used to process the output signal of the magnetoresistive sensor which is then mixed with the differentiated sinusoidal voltage signal of an oscillator and lowpass filtered in order to achieve a phase modulated output signal u(t).

It should be noted that the term "comprising" does not exclude other elements or features and the "a" or "an" does not exclude a plurality. Also elements described in association with different embodiments or aspects may be combined. It should also be noted that reference signs in the claims shall not be construed as limiting the scope of the claims.

**Claims**

1. A magnetoresistive sensor system (400) for linearizing a sensor transfer function comprising:

   a magnetic field source (402),
   a magnetoresistive sensor (403) having an easy axis, and
   an oscillator (401) providing an oscillating input signal (203) for the magnetic field source (402),
   wherein the magnetic field source (402) is adapted to emit an auxiliary magnetic field generated from the oscillating input signal, wherein the auxiliary magnetic field is orthogonal to the easy axis of the magnetoresistive sensor (403),
   wherein the magnetoresistive sensor (403) is adapted to sense a signal associated to a superposition of an external magnetic field and the auxiliary alternating magnetic field,
   **characterised in that**
   said magnetoresistive sensor system (400) comprises a differentiation element (404),
   wherein the differentiation element (404) is a band-pass filter adapted to differentiate the sensed signal in order to achieve a phase modulated sensed signal.

2. The magnetoresistive sensor system (400) according to claim 1,
   wherein the magnetoresistive sensor (402) is an anisotropic magnetoresistive sensor and/or and giant magnetoresistive sensor.

3. The magnetoresistive sensor system (400) according to claim 1, further comprising:

   a mixer (405) adapted to mix the differentiated signal and the oscillating input signal.

4. The magnetoresistive sensor system (400) according to claim 3, further comprising:

   a lowpass filter (406),
   wherein the lowpass filter (406) is adapted to filter the mixed filtered signal.

5. The magnetoresistive sensor system (400) according to claim 1, wherein the magnetic field source (402) is a coil.

6. A method of processing a signal of a magnetoresistive sensor (403), the method comprising:

   providing an oscillating input signal (203) for a magnetic field source (402),
   generating an auxiliary magnetic field orthogonal to an easy axis of the magnetoresistive sensor (403) from the oscillating input signal (203),
sensing a signal associated to a superposition of an external magnetic field and the auxiliary alternating magnetic field,
**characterised by** said method comprising
differentiate the sensed signal in order to achieve a phase modulated sensed signal.

**7.** A program element, which, when being executed by a processor, is adapted to carry out a method according to claim 6.

**8.** A computer-readable medium, in which a computer program is stored which, when being executed by a processor, is adapted to carry out a method according to claim 6.

## Patentansprüche

**1.** Ein magnetoresistives Sensorsystem (400) zum Linearisieren einer Sensortransferfunktion, welches aufweist:

eine magnetische Feldquelle (402),
einen magnetoresistiven Sensor (403), welcher eine leichte Achse hat, und
einen Oszillator (401), der ein oszillierendes Eingangssignal (203) für die magnetische Feldquelle (402) bereitstellt,
wobei die magnetische Feldquelle (402) eingerichtet ist, ein magnetisches Hilfsfeld zu emittieren, welches aus dem oszillierenden Eingangssignal generiert ist, wobei das magnetische Hilfsfeld orthogonal zu der leichten Achse des magnetoresistiven Sensors (403) ist,
wobei der magnetoresistive Sensors (403) eingerichtet ist, ein Signal abzutasten, welches mit einer Überlagerung eines externen magnetischen Feldes und dem alternierenden magnetischen Hilfsfeld assoziiert ist,
**dadurch gekennzeichnet, dass**
das magnetoresistive Sensorsystem (400) ein Differenzierungselement (404) aufweist,
wobei das Differenzierungselement (404) ein Bandpassfilter ist, welcher eingerichtet ist, das abgetastete Signal zu differenzieren, um ein phasenmoduliertes abgetastetes Signal zu erhalten.

**2.** Das magnetoresistive Sensorsystem (400) gemäß Anspruch 1, wobei der magnetoresistive Sensor (402) ein anisotroper magnetoresistive Sensor und/oder ein Riesen-Magnetwiderstands-Sensor ist.

**3.** Das magnetoresistive Sensorsystem (400) gemäß Anspruch 1, welches ferner aufweist:

einen Mischer (405), welcher eingerichtet ist, das differenzierte Signal und das oszillierende Eingangssignal zu mischen.

**4.** Das magnetoresistive Sensorsystem (400) gemäß Anspruch 3, welches ferner aufweist:

einen Tiefpassfilter (406),
wobei der Tiefpassfilter (406) eingerichtet ist, das gemischte gefilterte Signal zu filtern.

**5.** Das magnetoresistive Sensorsystem (400) gemäß Anspruch 1, wobei die magnetische Feldquelle (402) eine Spule ist.

**6.** Ein Verfahren zum Verarbeiten eines Signals eines magnetoresistiven Sensors (403), wobei das Verfahren aufweist:

Bereitstellen eines oszillierenden Eingangssignals (203) für eine magnetische Feldquelle (402),
Generieren eines magnetischen Hilfsfeldes aus dem oszillierenden Eingangssignal (203) senkrecht zu einer leichten Achse des magnetoresistiven Sensors (403),
Abtasten eines Signals, welches mit einer Überlagerung eines externen magnetisches Feldes und des alternierenden magnetischen Hilfsfeldes assoziiert ist,
**dadurch gekennzeichnet, dass** das Verfahren aufweist
Differenzieren des abgetasteten Signals, um ein phasenmoduliertes abgetastetes Signal zu erhalten.

**7.** Ein Programmelement, welches, wenn es mittels eines Prozessors ausgeführt wird, eingerichtet ist, ein Verfahren gemäß Anspruch 6 durchzuführen.

**8.** Ein computerlesbaren Medium, in welchem ein Computerprogramm gespeichert ist, welches, wenn es mittels eines Prozessors ausgeführt wird, eingerichtet ist, ein Verfahren gemäß Anspruch 6 durchzuführen.

## Revendications

**1.** Système de capteur magnéto-résistif (400) pour linéariser une fonction de transfert de capteur comprenant :

une source de champ magnétique (402),
un capteur magnéto-résistif (403) ayant un axe facile, et
un oscillateur (401) fournissant un signal oscillant d'entrée (203) pour la source de champ magnétique (402),
dans lequel la source de champ magnétique (402) est agencée de manière à émettre un champ magnétique auxiliaire généré à partir du signal oscillant d'entrée, dans lequel le champ magnétique auxiliaire est orthogonal à l'axe facile du capteur magnéto-résistif (403),
dans lequel le capteur magnéto-résistif (403) est agencé de manière à capter un signal associé à une superposition d'un champ magnétique externe et du champ magnétique alternatif auxiliaire, **caractérisé en ce que** ledit système de capteur magnéto-résistif (400) comporte un élément de dérivation (404),
dans lequel l'élément de dérivation (404) est un filtre passe-bande agencé de manière à dériver le signal capté pour obtenir un signal capté modulé en phase.

**2.** Système de capteur magnéto-résistif (400) selon la revendication 1,
dans lequel le capteur magnéto-résistif (402) est un capteur magnéto-résistif anisotrope et/ou un capteur magnéto-résistif géant.

**3.** Système de capteur magnéto-résistif (400) selon la revendication 1, comprenant en outre :

un mélangeur (405) agencé de manière à mélanger le signal dérivé et le signal oscillant d'entrée.

**4.** Système de capteur magnéto-résistif (400) selon la revendication 3, comprenant en outre :

un filtre passe-bas (406),
dans lequel le filtre passe-bas (406) est agencé de manière à filtrer le signal filtré mélangé.

**5.** Système de capteur magnéto-résistif (400) selon la revendication 1,
dans lequel la source de champ magnétique (402) est une bobine.

**6.** Procédé de traitement d'un signal d'un capteur magnéto-résistif (403), le procédé comprenant :

la fourniture d'un signal oscillant d'entrée (203) pour une source de champ magnétique (402),
la génération d'un champ magnétique auxiliaire orthogonal à un axe facile du capteur magnéto-résistif (403) à partir du signal oscillant d'entrée (203),
la détection d'un signal associé à une superposition d'un champ magnétique externe et du champ magnétique alternatif auxiliaire, **caractérisé en ce que** ledit procédé comprend
la dérivation du signal capté pour obtenir un signal capté modulé en phase.

**7.** Elément de programme, qui, lorsqu'il est exécuté par un processeur, est agencé de manière à mettre en oeuvre un procédé selon la revendication 6.

**8.** Support pouvant être lu par une machine, sur lequel est stocké un programme informatique, qui, lorsqu'il est exécuté par un processeur, est agencé de manière à mettre en oeuvre un procédé selon la revendication 6.

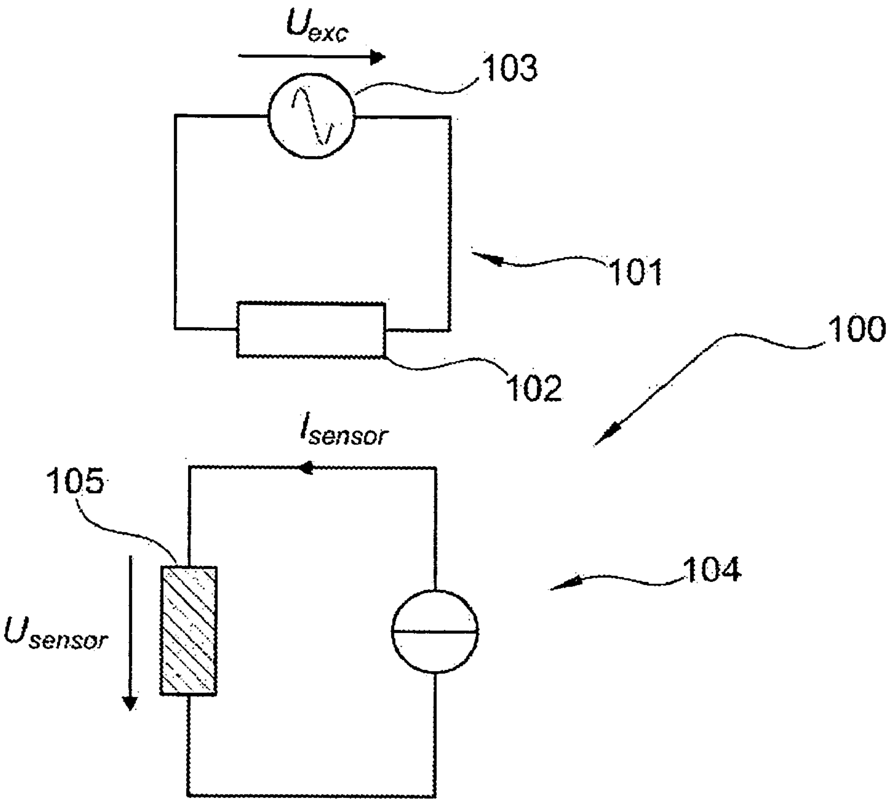

$U_{exc}$
103
101
100
102
$I_{sensor}$
105
104
$U_{sensor}$


Fig. 1

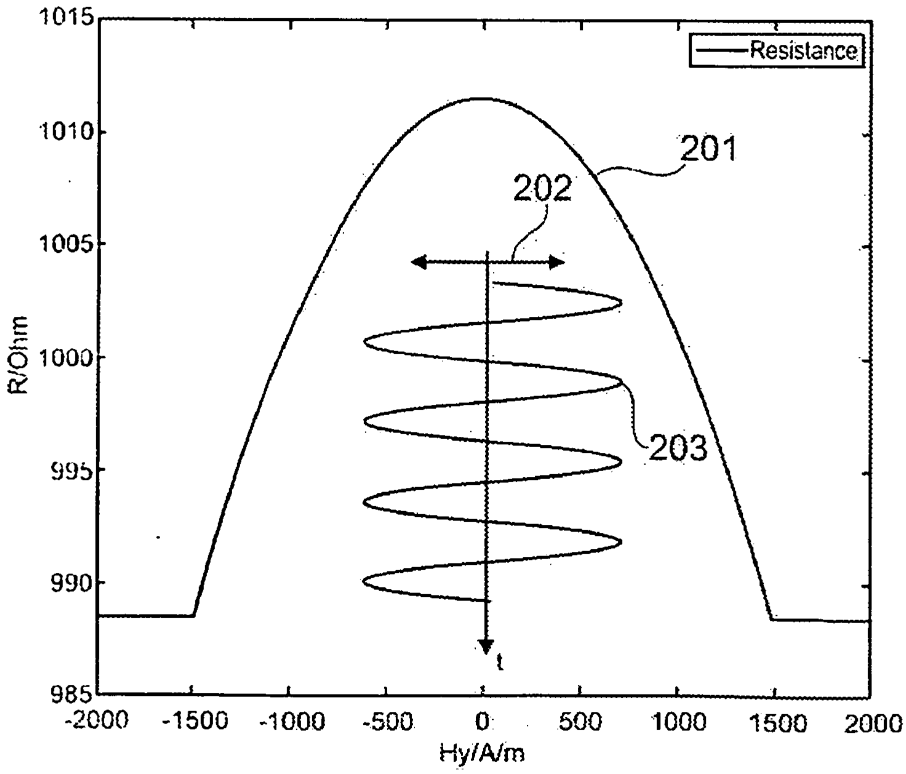

Resistance
201
202
203
t
R/Ohm
Hy/A/m
1015
1010
1005
1000
995
990
985
-2000
-1500
-1000
-500
0
500
1000
1500
2000


Fig. 2

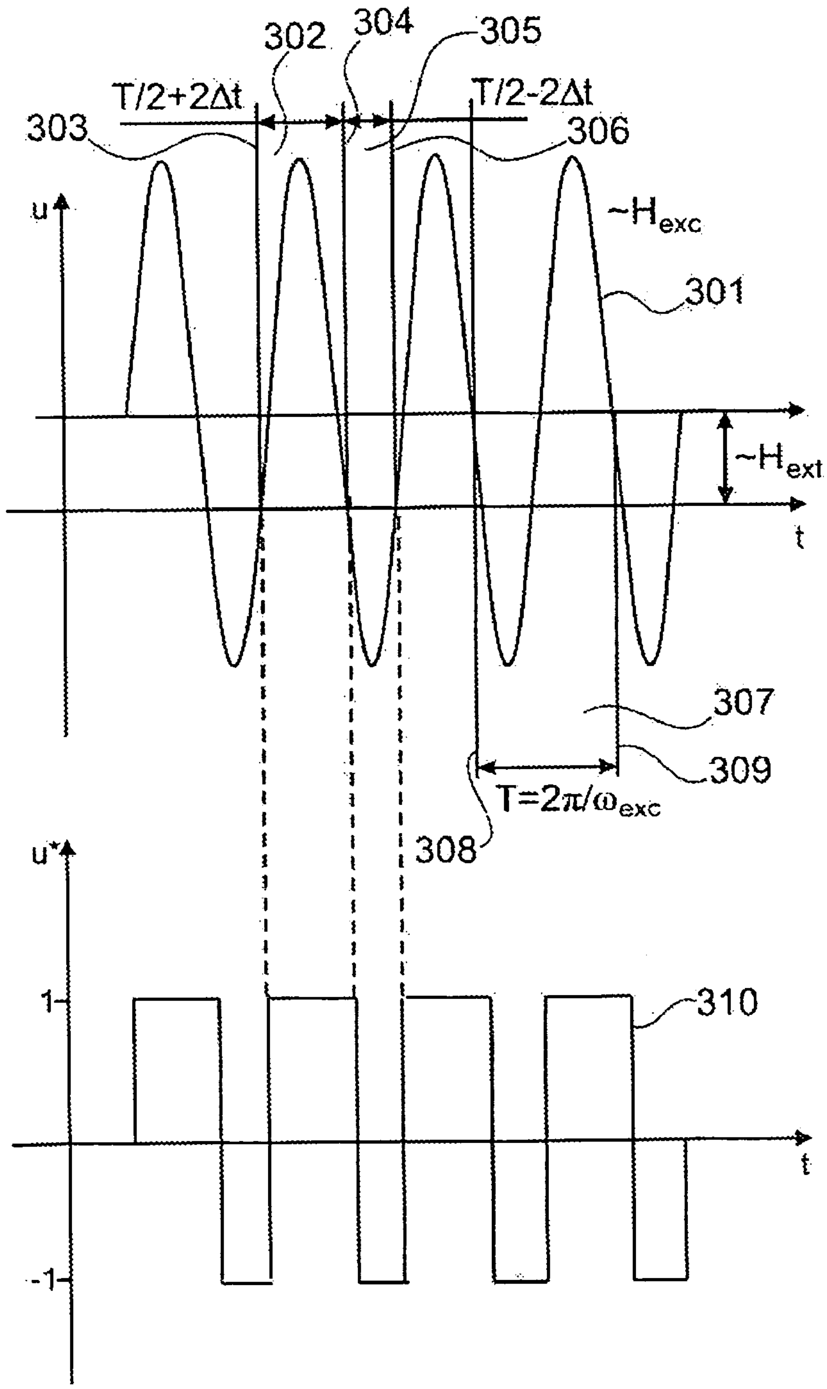
302
304
305
T/2+2Δt
T/2-2Δt
303
306
u
~Hexc
301
~Hext
t
307
309
T=2π/ωexc
308
u*
1
310
t
-1

Fig. 3

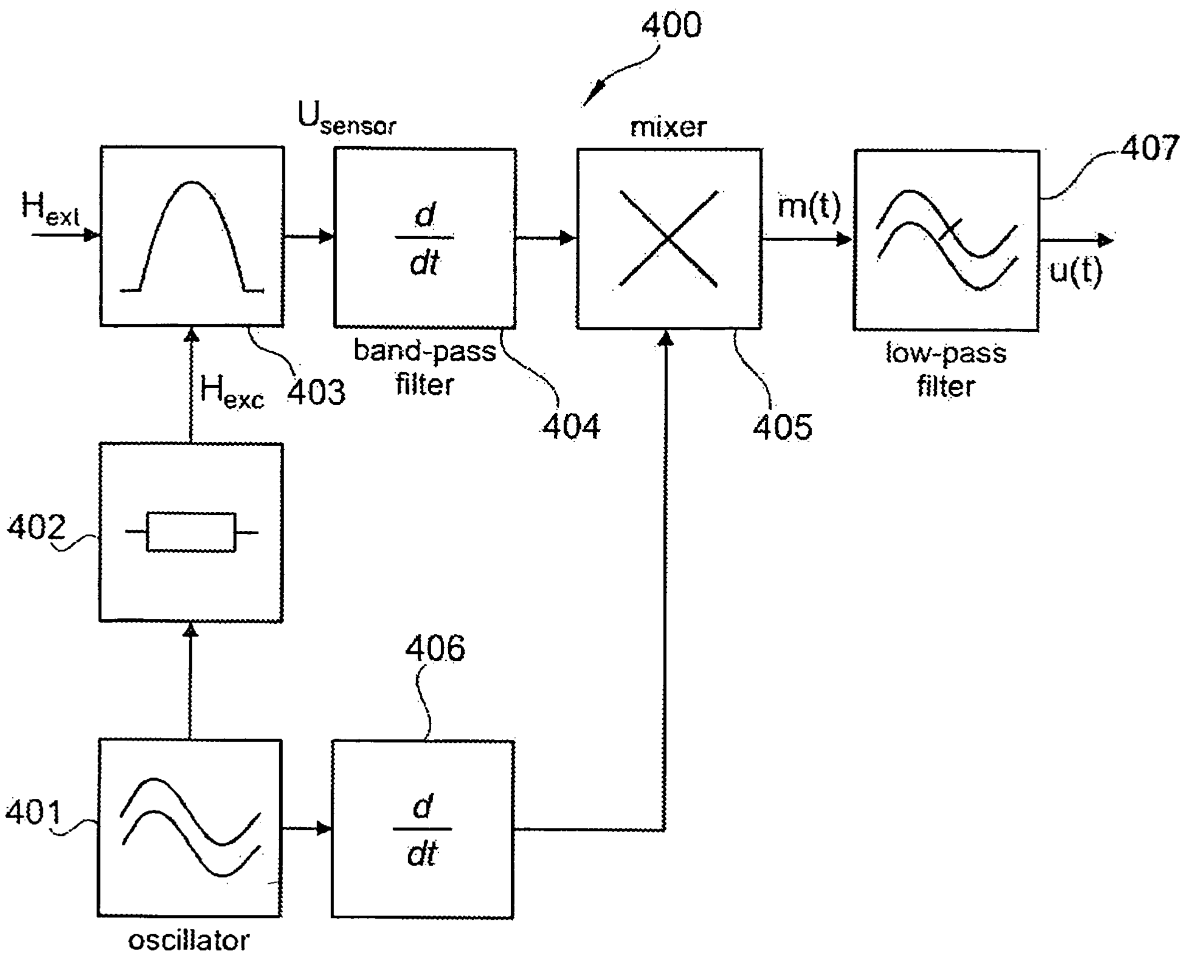
400
$U_{sensor}$
mixer
407
$H_{ext}$
d/dt
m(t)
u(t)
band-pass filter
low-pass filter
$H_{exc}$
403
404
405
402
406
401
d/dt
oscillator

Fig. 4

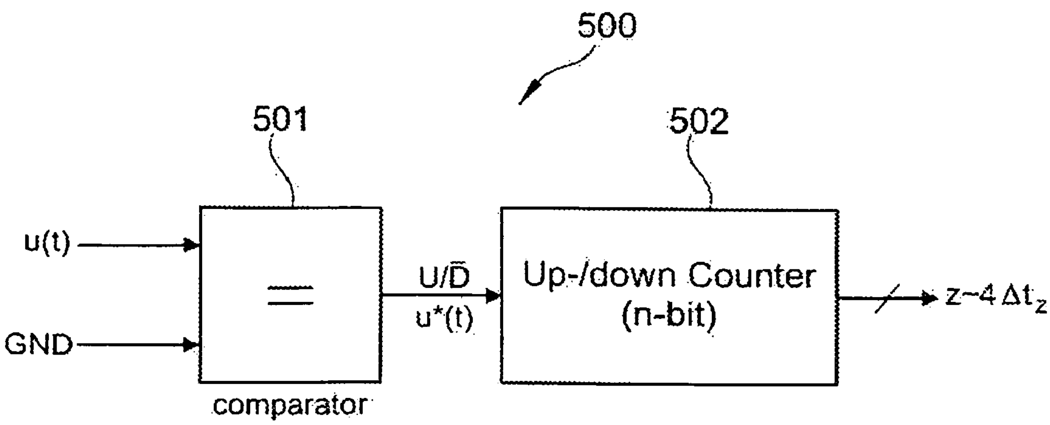
500
501
502
u(t)
GND
U/D̄
u*(t)
Up-/down Counter (n-bit)
z~4 Δt_z
comparator

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4703378 A
- US 2006132125 A1


### Non-patent literature cited in the description


- **FLYNN D.** Demodulation of a magnetoresistive sensor signal to achieve a low-cost stable and high-resolution vector magnetometer. *Sensors and Actuators A,* 1995, vol. 50, 187-190